# DEMANDE DE BREVET EUROPEEN

(11) **EP 2 991 115 A1**
(43) Date de publication de la demande: **02.03.2016**
(21) Numéro de dépôt: 15182806.8
(22) Date de dépôt: 27.08.2015
(51) Int. Cl.: H01L 27/146

(54) **CAPTEUR PHOTOSENSIBLE**

(30) Priorité: 29.08.2014 FR 1458128
(71) Demandeur: COMMISSARIAT A L'ENERGIE ATOMIQUE ET AUX ENERGIES ALTERNATIVES, 75015 Paris (FR)
(72) Inventeur: PALANCHOKE, Ujwol, 13001 Marseille (FR); BOUTAMI, Salim, 38100 Grenoble (FR); GIDON, Serge, 38140 La Murette (FR)
(74) Mandataire: Thibon, Laurent

(57) **Abrégé**

L'invention concerne un capteur photosensible (100) comprenant : des première (D1) et deuxième (D2) cellules photosensibles juxtaposées formées dans un substrat semiconducteur (101) ; des première (103) et deuxième (105) couches diélectriques d'interface revêtant respectivement les première (D1) et deuxième (D2) cellules ; et un réseau de résonance (107) formé dans une troisième couche diélectrique (109) revêtant les première (103) et deuxième (105) couches d'interface, dans lequel les première (103) et deuxième (105) couches d'interface présentent des épaisseurs différentes, ou des indices de réfraction différents, ou des épaisseurs et des indices de réfraction différents.

## Description

### Domaine

La présente demande concerne le domaine des capteurs photosensibles adaptés à mesurer des intensités lumineuses reçues dans plusieurs gammes de longueurs d'onde déterminées, par exemple des capteurs d'images couleur.

### Exposé de l'art antérieur

Classiquement, un capteur d'images couleur comprend une pluralité de cellules photosensibles élémentaires (ou pixels) identiques ou similaires, formées dans et sur un substrat semiconducteur et disposées selon des lignes et des colonnes. Chaque cellule photosensible est revêtue d'un filtre couleur, par exemple une couche de résine colorée, ne transmettant à la cellule que la lumière d'une gamme de longueurs d'onde spécifique. L'ensemble des filtres couleur forme une mosaïque de filtrage disposée au-dessus de la matrice de cellules photosensibles. A titre d'exemple, un capteur d'images couleur peut comprendre des filtres rouge, vert et bleu, disposés selon un motif de Bayer au-dessus des cellules photosensibles.

Un inconvénient des capteurs d'images couleur classiques réside dans leur faible rendement de conversion photoélectrique. En effet, chaque filtre couleur transmet à la cellule photosensible sous-jacente la lumière d'une gamme de longueurs d'onde spécifique, et réfléchit ou absorbe la lumière hors de cette gamme de longueurs d'ondes. Ainsi, si on considère, à titre d'exemple illustratif, un capteur photosensible comportant trois pixels de mêmes dimensions revêtus respectivement par un filtre rouge, un filtre vert, et un filtre bleu, le pixel rouge reçoit seulement environ un tiers de la lumière rouge reçue sur l'ensemble de la surface de collecte du capteur, le pixel vert reçoit seulement environ un tiers de la lumière verte reçue sur l'ensemble de la surface de collecte du capteur, et le pixel bleu reçoit seulement environ un tiers de la lumière bleue reçue sur l'ensemble de la surface de collecte du capteur.

Ceci pose notamment problème lorsque l'on cherche à réaliser des capteurs comportant des pixels de petites dimensions, par exemple en vue d'augmenter la résolution du capteur et/ou de réduire son encombrement. La faible surface de collecte de photons disponible pour chaque couleur se traduit alors en effet par une faible sensibilité et un faible rapport signal sur bruit du capteur.

L'article "Plasmonic photon sorters for spectral and polarimetric imaging" de Eric Laux et al. (Nature Photonics 2, 161 - 164 (2008)), décrit un dispositif de tri spectral permettant de séparer, par gammes de longueurs d'onde, des photons reçus sur une surface de collecte, et de transmettre ces photons à des cellules photosensibles distinctes. Dans ce dispositif, la surface de collecte est une surface métallique structurée à l'échelle nanométrique, sur laquelle la lumière incidente est convertie en plasmons. Les motifs de la surface métallique de collecte sont choisis de façon à provoquer une focalisation des plasmons dans des zones distinctes de la surface de collecte, selon la longueur d'onde. Une fois le tri effectué, les plasmons sont à nouveau convertis en photons, illuminant les différentes cellules photosensibles. Chaque cellule photosensible reçoit ainsi des photons d'une gamme de longueurs d'ondes spécifique, collectés sur une surface de collecte supérieure à la surface de la cellule.

Un inconvénient de ce dispositif réside dans sa complexité de réalisation, et dans les pertes relativement élevées résultant de la conversion photon-plasmon-photon par la structure métallique du dispositif.

Il serait souhaitable de pouvoir disposer d'un capteur photosensible adapté à mesurer des intensités lumineuses reçues dans plusieurs gammes de longueurs d'onde distinctes, ce capteur palliant tout ou partie des inconvénients des capteurs existants.

### Résumé

Ainsi, un mode de réalisation prévoit un capteur photosensible comprenant : des première et deuxième cellules photosensibles juxtaposées formées dans un substrat semiconducteur ; des première et deuxième couches diélectriques d'interface revêtant, et étant en contact avec, respectivement les première et deuxième cellules ; et un réseau de résonance formé dans une troisième couche revêtant, et étant en contact avec, les première et deuxième couches d'interface, dans lequel les première et deuxième couches d'interface présentent des épaisseurs différentes, ou des indices de réfraction différents, ou des épaisseurs et des indices de réfraction différents.

Selon un mode de réalisation, le réseau de résonance comprend des bandes ou alignements de plots, parallèles au bord adjacent entre les première et deuxième cellules, délimitées par des ouvertures verticales formées dans la troisième couche.

Selon un mode de réalisation, le bord adjacent entre les première et deuxième cellules est situé sous une bande ou sous un alignement de plots du réseau de résonance.

Selon un mode de réalisation, l'ensemble comprenant la première couche d'interface et le réseau de résonance est choisi pour avoir une première longueur d'onde de résonance définissant une première longueur d'onde de sensibilité du capteur, et l'ensemble comprenant la deuxième couche d'interface et le réseau de résonance est choisi pour avoir une deuxième longueur d'onde de résonance distincte de la première longueur d'onde de résonance, définissant une deuxième longueur d'onde de sensibilité du capteur.

Selon un mode de réalisation, chacune des première et deuxième cellules a une largeur comprise entre λm/2 et 2λm, où λm désigne la longueur d'onde moyenne de sensibilité du capteur.

Selon un mode de réalisation, le réseau de résonance a un pas compris entre λm/4 et λm, où λm désigne la longueur d'onde moyenne de sensibilité du capteur.

Selon un mode de réalisation, chacune des première, deuxième et troisième couches a une épaisseur comprise entre λm/8 et λm, où λm désigne la longueur d'onde moyenne de sensibilité du capteur.

Selon un mode de réalisation, le capteur comporte en outre une troisième cellule photosensible formée dans le substrat, et une quatrième couche diélectrique d'interface revêtant la troisième cellule.

Selon un mode de réalisation, l'ensemble comprenant la quatrième couche diélectrique d'interface et le réseau de résonance est choisi pour avoir une troisième longueur d'onde de résonance, distincte des première et deuxième longueurs d'onde de résonance, définissant une troisième longueur d'onde de sensibilité du capteur.

Selon un mode de réalisation, chaque couche diélectrique d'interface est en un matériau du groupe comprenant l'oxyde de silicium, le nitrure de silicium, le MgF₂, le HfO₂, le Al₂O₃, le Ta₂O₅, le TiO₂, le ZnS, et le ZrO₂.

Selon un mode de réalisation, la troisième couche est en un matériau du groupe comprenant le dioxyde de titane, le SiN, le Ta₂O₅, le HfO₂, le silicium et le germanium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en perspective schématique et une vue en coupe schématique illustrant un exemple d'un mode de réalisation d'un capteur photosensible ;
la figure 3 est un diagramme illustrant de façon schématique la réponse du capteur des figures 1 et 2 en fonction de la longueur d'onde d'éclairement ;
la figure 4 est une vue de dessus schématique et partielle illustrant une variante de réalisation d'un capteur photosensible ; et
la figure 5 est une vue de dessus schématique illustrant une autre variante de réalisation d'un capteur photosensible.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Par ailleurs, dans la suite de la description, sauf indication contraire, les termes "approximativement", "sensiblement", "environ", "de l'ordre de", etc., signifient "à 10% près", et des références directionnelles telles que "supérieur", "inférieur", "surmontant" "au-dessus" "latéral", "horizontal", "vertical", etc., s'appliquent à des dispositifs orientés de la façon illustrée dans les vues en coupe correspondantes, étant entendu que, dans la pratique, ces dispositifs peuvent être orientés différemment.

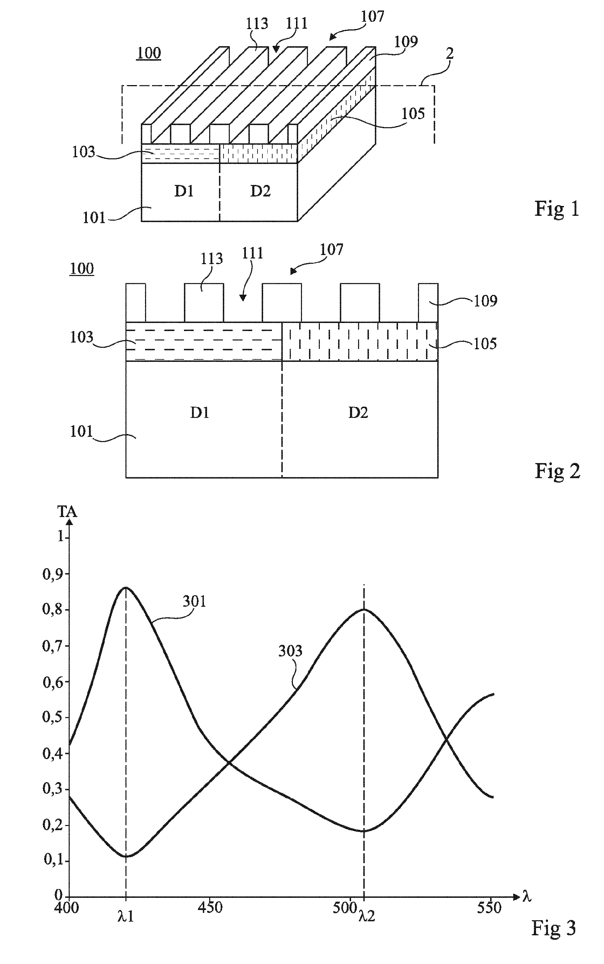

La figure 1 est une vue en perspective schématique illustrant un exemple d'un mode de réalisation d'un capteur photosensible 100 adapté à mesurer des intensités lumineuses reçues dans deux gammes de longueurs d'ondes distinctes. La figure 2 est une vue en coupe agrandie de la structure de la figure 1 dans le plan 2 de la figure 1.

Dans l'exemple représenté, le capteur 100 comprend deux cellules photosensibles élémentaires D1 et D2 juxtaposées, formées dans un substrat semiconducteur 101, par exemple un substrat de silicium, de germanium, de silicium-germanium, ou de tout autre matériau semiconducteur adapté à la réalisation de cellules photosensibles. A titre d'exemple, chaque cellule comprend un détecteur de photons, par exemple une photodiode, et un ou plusieurs transistors MOS de contrôle. Les cellules D1 et D2 peuvent être identiques ou similaires. Dans cet exemple, vu de dessus, les cellules D1 et D2 ont une forme sensiblement rectangulaire. Les modes de réalisation décrits ne se limitent toutefois pas à ce cas particulier.

La cellule D1 est revêtue, du côté de sa face destinée à recevoir la lumière (c'est-à-dire sa face supérieure dans l'exemple représenté), par une couche d'interface 103 en un matériau diélectrique. Dans l'exemple représenté, la couche 103 recouvre sensiblement toute la surface de la cellule D1. En outre, la cellule D2 est revêtue, du côté de sa face destinée à recevoir la lumière (c'est-à-dire sa face supérieure dans l'exemple représenté), par une couche d'interface 105 en un matériau diélectrique. Dans l'exemple représenté, la couche 105 recouvre sensiblement toute la surface de la cellule D2. Dans cet exemple, les couches 103 et 105 sont sensiblement de même épaisseur, et présentent des indices de réfraction différents. Les couches 103 et 105 sont de préférence transparentes. A titre d'exemple, les couches 103 et 105 sont en des matériaux choisis dans le groupe comprenant l'oxyde de silicium, le nitrure de silicium, le MgF₂, le HfO₂, le Al₂O₃, le Ta₂O₅, le TiO₂, le ZnS, et le ZrO₂.

Le capteur 100 comprend en outre un réseau de résonance 107 formé dans une troisième couche 109, de préférence non métallique, revêtant les couches d'interface 103 et 105. La couche 109 est de préférence transparente. La couche 109 est par exemple en un matériau d'indice de réfraction différent de celui des couches 103 et 105. A titre d'exemple, la couche 109 est en un matériau choisi dans le groupe comprenant le dioxyde de titane, le SiN, le Ta₂O₅, le HfO₂, le silicium et le germanium. Le réseau 107 recouvre sensiblement toute la surface supérieure de l'ensemble formé par les cellules D1 et D2 et les couches d'interface 103 et 105. Le réseau 107 comprend des ouvertures verticales 111 formées dans la couche 109, réparties sur toute la surface du capteur. Dans l'exemple représenté, les ouvertures 111 formées dans la couche 109 sont traversantes, c'est-à-dire qu'elles s'étendent sur toute l'épaisseur de la couche 109, et débouchent sur les couches d'interface 103, 105 sous-jacentes. Les modes de réalisation décrits ne se limitent toutefois pas à ce cas particulier. À titre de variante, les ouvertures 111 définissant le réseau 107 peuvent s'étendre depuis la face supérieure de la couche 109, et s'interrompre à une hauteur intermédiaire de la couche 109 sans la traverser entièrement. Le réseau 107 peut être revêtu d'un matériau de protection (non représenté) d'indice de réfraction inférieur à celui de la couche 109, remplissant notamment les ouvertures 111 du réseau, ou être laissé à l'air libre tel que représenté sur les figures 1 et 2.

Dans l'exemple des figures 1 et 2, les ouvertures 111 ont la forme de fentes parallèles au bord adjacent entre les cellules D1 et D2, s'étendant sur sensiblement toute la longueur du capteur parallèlement au bord adjacent aux cellules D1 et D2, et délimitant dans la couche 109 des bandes 113 parallèles au bord adjacent entre les cellules D1 et D2. A titre d'exemple, dans une direction parallèle à la largeur du capteur, c'est-à-dire perpendiculairement au bord adjacent entre les cellules D1 et D2, les fentes 111 et les bandes 113 définissent un motif périodique se répétant sur sensiblement toute la largeur du capteur. Les modes de réalisation décrits ne se limitent toutefois pas à ce cas particulier. A titre de variante, le pas d'espacement des fentes 111, et/ou le rapport entre la largeur des fentes 111 et la largeur des bandes 113, peuvent ne pas être exactement les mêmes au-dessus de la couche d'interface 103 (et donc de la cellule D1) et au-dessus de la couche d'interface 105 (et donc de la cellule D2).

Pour illustrer le comportement d'un capteur du type décrit en relation avec les figures 1 et 2, on considère, à titre d'exemple non limitatif, le cas particulier suivant : les cellules D1 et D2 ont chacune une largeur (perpendiculairement au bord adjacent entre les cellules) d'environ 500 nm, et sont formées dans un substrat de silicium, la couche d'interface 103 est en nitrure de silicium d'indice n=2, la couche d'interface 105 est en oxyde de silicium d'indice n=1,45, les couches 103 et 105 présentent une épaisseur d'environ 110 nm, la couche 109 dans laquelle est formé le réseau 107 est en dioxyde de titane d'indice n=2,5 et présente une épaisseur d'environ 110 nm, les fentes 111 ont une largeur d'environ 125 nm et sont réparties périodiquement sur toute la largeur du capteur (perpendiculairement au bord adjacent entre les cellules D1 et D2) avec un pas d'environ 250 nm, et le réseau 107 est revêtu d'une couche d'air d'indice n=1.

La figure 3 est un diagramme illustrant schématiquement la réponse, en fonction de la longueur d'onde, de chacune des cellules D1 et D2 du capteur 100, pour cet exemple particulier de dimensionnement et de choix de matériaux du capteur. Plus particulièrement, la figure 3 comprend une courbe 301 représentant l'évolution, en fonction de la longueur d'onde λ, du taux d'absorption normalisé TA de la lumière par la cellule D1, et une courbe 303 représentant l'évolution, en fonction de la longueur d'onde λ, du taux d'absorption normalisé TA de la lumière par la cellule D2. Par taux d'absorption normalisé, on entend ici la proportion, absorbée par la cellule D1 (respectivement D2), de la lumière reçue sur l'ensemble de la surface supérieure du capteur située en regard des cellules D1 et D2 (ou surface totale de collecte du capteur). Dans l'exemple représenté, les courbes 301 et 303 ont été tracées pour une plage de longueur d'ondes λ allant de 400 à 550 nm.

Dans cet exemple, la courbe 301 comprend un pic d'absorption centré sur une valeur de longueur d'onde λ1 d'environ 430 nm, et atteignant une valeur de crête (ou un maximum) d'absorption de l'ordre de 0,87 à cette longueur d'onde, et comprend en outre un creux d'absorption centré sur une valeur de longueur d'onde λ2 d'environ 520 nm, et atteignant une valeur de creux (ou un minimum) d'absorption de l'ordre 0,2 à cette longueur d'onde. De plus, dans cet exemple, la courbe 303 comprend un creux d'absorption centré sur la valeur de longueur d'onde λ1, et atteignant une valeur de creux (ou un minimum) d'absorption de l'ordre de 0,13 à cette longueur d'onde, et comprend en outre un pic d'absorption centré sur la valeur de longueur d'onde λ2, et atteignant une valeur de crête (ou un maximum) d'absorption de l'ordre 0,8 à cette longueur d'onde. En d'autres termes, à la longueur d'onde λ1, la cellule D1 absorbe environ 87% des photons reçus sur la surface totale de collecte du capteur, et la cellule D2 n'absorbe qu'environ 13% des photons reçus, et, à la longueur d'onde λ2, la cellule D2 absorbe environ 80% des photons reçus sur la surface totale de collecte du capteur, et la cellule D1 n'absorbe qu'environ 20% des photons reçus. A titre d'exemple comparatif, si, au lieu de la structure formée par les couches d'interface 103 et 105 et le réseau de résonance 107, les cellules D1 et D2 étaient recouvertes par de simples filtres adaptés à transmettre respectivement la longueur d'onde λ1 (cellule D1) et la longueur d'onde λ2 (cellule D2), le taux d'absorption normalisé TA de la cellule D1 à la longueur d'onde λ1 serait de l'ordre de 0,5, et le taux d'absorption normalisé TA de la cellule D2 à la longueur d'onde λ2 serait de l'ordre de 0,5.

Ainsi, le capteur 100 réalise un tri des photons en fonction de la longueur d'onde. En particulier, la prévision des couches d'interface 103 et 105 et du réseau de résonance 107 permet que chaque cellule photosensible reçoive essentiellement des photons d'une gamme de longueurs d'ondes spécifique, collectés sur une surface de collecte supérieure à la surface supérieure de la cellule.

Le capteur 100 permet ainsi de mesurer des intensités lumineuses reçues aux longueurs d'ondes λ1 et λ2, avec un rendement de conversion photoélectrique nettement supérieur à ce qui pourrait être obtenu en utilisant de simples filtres colorés pour séparer les longueurs d'onde λ1 et λ2 (à surfaces totales de collecte de photons identiques).

Les inventeurs ont déterminé que l'effet observé d'extension de la surface de collecte des photons, aux longueurs d'onde λ1 et λ2, est lié au fait que la couche d'interface 103 et le réseau 107 forment une structure résonante à la longueur d'onde λ1, et que la couche d'interface 105 et le réseau 107 forment une structure résonante à la longueur d'onde λ2.

Par des méthodes d'analyse et de simulation adaptées, par exemple des méthodes du type généralement désigné dans la technique par l'acronyme RCWA (de l'anglais "Rigorous Coupled-Wave Analysis"), l'exemple particulier de dimensionnement susmentionné peut aisément être adapté pour obtenir des résonances, et donc des pics d'absorption, à d'autres longueurs d'onde λ1 et λ2 que celles de l'exemple de la figure 3. En particulier, un ou plusieurs des paramètres suivants peuvent être modifiés : la largeur des cellules D1 et D2, les épaisseurs des couches 103 et 105 et de la couche 109, le pas du réseau 107, la largeur des fentes du réseau 107, et l'indice optique des couches 103, 105 et/ou 109.

Pour obtenir un rendement de conversion particulièrement élevé, les inventeurs ont constaté qu'il est préférable que la largeur des cellules photosensibles soit comprise entre λm/2 et 2λm, où λm désigne la longueur d'onde moyenne des photons à filtrer ou longueur d'onde moyenne de sensibilité du capteur (c'est-à-dire λm = (λ1 + λ2)/2 dans l'exemple à deux gammes de filtrage décrit en relation avec les figures 1 et 2). De plus, le pas du réseau de résonance 107 est de préférence compris entre λm/4 et λm. A titre d'exemple, le pas du réseau 107 est de l'ordre de λm/2. En outre, les épaisseurs des couches d'interface 103 et 105 d'une part, et de la couche 109 d'autre part, sont de préférence comprises entre λm/8 et λm. A titre d'exemple, les couches 103, 105 et 109 ont une épaisseur d'environ λm/4.

Par ailleurs, les inventeurs ont constaté qu'un rendement particulièrement élevé est obtenu lorsque l'une des bandes 113 du réseau de résonance 107 se situe au-dessus du bord adjacent entre les cellules D1 et D2, et que le bord adjacent entre les cellules D1 et D2 coïncide approximativement (en projection verticale) avec l'axe longitudinal central de cette bande, comme représenté sur les figures 1 et 2.

Les modes de réalisation décrits ne se limitent pas à l'exemple particulier décrit ci-dessus dans lequel les couches d'interface 103 et 105 sont de même épaisseur et présentent des indices de réfraction différents. A titre de variante, les couches 103 et 105 peuvent être en un même matériau (et donc avoir des indices de réfraction identiques) mais avoir des épaisseurs différentes. De plus, les couches 103 et 105 peuvent être en des matériaux d'indices de réfraction distincts et avoir des épaisseurs différentes.

Par ailleurs, on a décrit ci-dessus, à titre illustratif, un exemple particulier de capteur photosensible comportant uniquement deux cellules photosensibles D1 et D2 destinées à recevoir chacune des photons d'une gamme spécifique de longueurs d'ondes (λ1 et λ2 respectivement). Les modes de réalisation décrits ne se limitent toutefois pas à cet exemple particulier.

A titre de variante, on peut notamment prévoir un capteur d'images bicolores comportant un nombre plus important de cellules photosensibles, disposées selon des lignes et des colonnes. A titre d'exemple, pour former un tel capteur, la structure des figures 1 et 2 peut être répétée dans le sens de la largeur et dans le sens de la longueur du capteur 100, autant de fois que nécessaire pour obtenir la résolution souhaitée.

Par ailleurs, l'exemple décrit en relation avec les figures 1 et 2 peut être étendu à un capteur permettant de discriminer un nombre de bandes de longueurs d'ondes supérieur à 2. A titre d'exemple, une troisième cellule photosensible peut être prévue, juxtaposée à l'une des cellules D1 et D2, cette troisième cellule étant surmontée par une troisième couche d'interface d'indice optique différent et/ou d'épaisseur différente des couches 103 et 105, et par un prolongement du réseau 107.

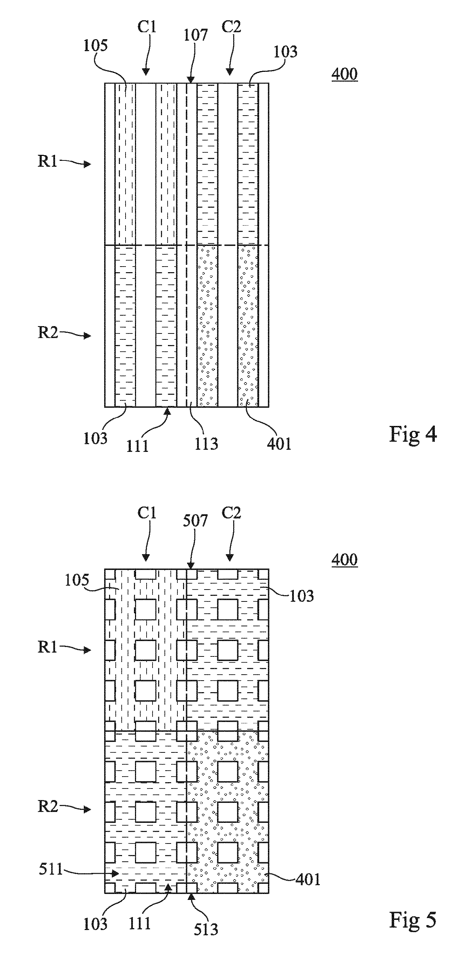

La figure 4 est une vue de dessus schématique et partielle illustrant une variante de réalisation d'un capteur photosensible 400 adapté à mesurer l'intensité lumineuse reçue dans trois bandes de longueurs d'onde spécifiques. Dans l'exemple représenté, le capteur 400 comprend quatre cellules photosensibles (non visibles sur la figure 4) identiques ou similaires, formées dans un substrat semiconducteur (non visible sur la figure 1), et disposées en matrice selon deux lignes R1 et R2 et deux colonnes C1 et C2. Pour des raisons pratiques, bien que les cellules photosensibles ne soient pas visibles sur la figure 4, on désignera ci-après par les références D11, D12, D21 et D22 respectivement la cellule de la ligne R1 et de la colonne C1, la cellule de la ligne R1 et de la colonne C2, la cellule de la ligne R2 et de la colonne C1, et la cellule de la ligne R2 et de la colonne C2.

Les cellules D11 et D12 d'une part, et D21 et D22 d'autre part, sont juxtaposées. De plus, dans cet exemple, les cellules D11 et D21 d'une part, et D12 et D22 d'autre part, sont juxtaposées. La cellule D11 est revêtue d'une couche d'interface 105 identique ou similaire à celle des figures 1 et 2, et les cellules D12 et D21 sont revêtues d'une couche d'interface 103 identique ou similaire à celle des figures 1 et 2. La cellule D22 est quant à elle recouverte d'une troisième couche d'interface 401 en un matériau diélectrique, cette couche 401 différant des couches 103 et 105 par son indice de réfraction et/ou par son épaisseur.

Un réseau de résonance 107 identique ou similaire à celui des figures 1 et 2 revêt l'ensemble de la structure formée par les cellules D11, D12, D21 et D22 et par les couches d'interface 103, 105 et 401. Dans le capteur 400, les bandes parallèles 113 du réseau de résonance sont disposées parallèlement aux colonnes du capteur. De préférence, l'une des bandes 113 du réseau de résonance est située au-dessus du bord adjacent entre les colonnes C1 et C2, c'est-à-dire au-dessus du bord adjacent entre les cellules D11 et D12 et au-dessus du bord adjacent entre les cellules D21 et D22.

A titre d'exemple, le réseau 107 et les couches d'interface 103, 105 et 401 sont choisies de façon que la cellule D11 présente un pic d'absorption dans le bleu, que la cellule D22 présente un pic d'absorption dans le rouge, et que les cellules D12 et D21 présentent un pic d'absorption dans le vert. Ainsi, on obtient un capteur dont la disposition des pixels correspond à celle d'un filtre de Bayer. Un capteur présentant un nombre plus important de cellules photosensibles peut être réalisé en répétant la structure de la figure 4 dans le sens des lignes et dans le sens des colonnes, autant de fois que nécessaire pour obtenir la résolution souhaitée.

La figure 5 est une vue de dessus schématique et partielle illustrant une variante de réalisation du capteur photosensible 400 de la figure 4. Le capteur 400 de la figure 5 diffère du capteur de la figure 4 par la forme de son réseau de résonance. Dans l'exemple de la figure 5, le capteur 400 comprend un réseau de résonance 507 qui diffère du réseau 107 de la figure 4 en ce que chaque bande 113 du réseau 107 est remplacée par un alignement 513 de plots disjoints, régulièrement répartis sur toute la longueur du capteur. En d'autres termes, outre les fentes 111 parallèles au bord adjacent entre les colonnes C1 et C2, le réseau 507 comprend des fentes 511 perpendiculaires au bord adjacent entre les colonnes C1 et C2, régulièrement réparties sur toute la longueur du capteur.

On notera que cette variante de réalisation est aussi compatible avec l'exemple des figures 1 et 2, dans lequel chaque bande 113 du réseau 107 peut être remplacée par une pluralité de plots disjoints alignés selon la même direction longitudinale que la bande 113.

Un avantage des modes de réalisation décrits est qu'ils permettent de mesurer des intensités lumineuses dans des gammes de longueurs d'ondes distinctes avec un rendement de conversion photoélectrique élevé par rapport aux capteurs existants. Ce rendement élevé provient notamment du fait que, du fait de la résonance de réseau à une couleur donnée, les photons semblent être collectés sur une surface de collecte supérieure à la surface de la cellule photosensible. Par ailleurs, l'utilisation de matériaux diélectriques pour former les couches d'interface et le réseau de résonance contribue à l'obtention d'un rendement de conversion photoélectrique élevée, dans la mesure où ces matériaux présentent de faibles pertes aux longueurs d'onde de sensibilité du capteur. Ainsi, on peut réaliser des capteurs compacts, présentant une sensibilité élevée et un fort rapport signal sur bruit par rapport aux capteurs existants.

De plus, les capteurs décrits sont aisément réalisables par des techniques habituelles de fabrication de circuits intégrés.

Des modes de réalisation particuliers ont été décrits. Diverses variantes et modifications apparaîtront à l'homme de l'art.

En particulier, les modes de réalisation décrits ne se limitent pas aux exemples susmentionnés quant au nombre de bandes de longueur d'ondes distinctes pouvant être détectées par le capteur et quant aux valeurs moyennes de ces longueurs d'onde. Plus généralement, à partir de l'enseignement décrit ci-dessus, l'homme de l'art pourra aisément réaliser un capteur photosensible permettant de mesurer des intensités lumineuses dans au moins deux gammes de longueurs d'onde distinctes choisies dans le domaine du visible ou proche du visible, par exemple dans la plage de longueurs d'ondes allant de 100 à 10000 nm.

Par ailleurs, pour améliorer la discrimination des couleurs, des filtres couleurs, par exemple des couches de résine colorées, peuvent optionnellement être ajoutés aux structures décrites ci-dessus. A titre d'exemple, dans le capteur 400 de la figure 4, si on considère le cas où les cellules D11, D12, D21 et D22 présentent des pics d'absorption respectivement dans le bleu, le vert, le vert et le rouge (motif de Bayer), on peut prévoir de disposer un filtre cyan au-dessus de l'ensemble formé par les cellules D11 et D12, et un filtre jaune au-dessus de l'ensemble formé par les cellules D21 et D22. Le filtre cyan permet en effet de filtrer la lumière rouge et de ne transmettre aux cellules D11 et D12 que la lumière bleue et verte, et le filtre jaune permet de filtrer la lumière bleue et de ne transmettre aux cellules D21 et D22 que la lumière verte et rouge.

## Revendications

1. Capteur photosensible (100 ; 400) comprenant :
des première (D1 ; D12) et deuxième (D2 ; D11) cellules photosensibles juxtaposées formées dans un substrat semiconducteur (101) ;
des première (103) et deuxième (105) couches diélectriques d'interface revêtant, et étant en contact avec, respectivement les première (D1 ; D12) et deuxième (D2 ; D11) cellules ; et
un réseau de résonance (107 ; 507) formé dans une troisième couche (109) revêtant, et étant en contact avec, les première (103) et deuxième (105) couches d'interface,
dans lequel les première (103) et deuxième (105) couches d'interface présentent des épaisseurs différentes, ou des indices de réfraction différents, ou des épaisseurs et des indices de réfraction différents.

2. Capteur (100 ; 400) selon la revendication 1, dans lequel le réseau de résonance (107 ; 507) comprend des bandes (113) ou alignements de plots (513), parallèles au bord adjacent entre les première (D1 ; D12) et deuxième (D2 ; D11) cellules, délimitées par des ouvertures (111 ; 511) verticales formées dans la troisième couche (109).

3. Capteur (100 ; 400) selon la revendication 2, dans lequel le bord adjacent entre les première (D1 ; D12) et deuxième (D2 ; D11) cellules est situé sous une bande (113) ou sous un alignement de plots (513) du réseau de résonance (107 ; 507).

4. Capteur (100 ; 400) selon l'une quelconque des revendications 1 à 3, dans lequel l'ensemble comprenant la première couche d'interface (103) et le réseau de résonance (107 ; 507) est choisi pour avoir une première longueur d'onde de résonance (λ1) définissant une première longueur d'onde de sensibilité du capteur, et dans lequel l'ensemble comprenant la deuxième couche d'interface (105) et le réseau de résonance (107) est choisi pour avoir une deuxième longueur d'onde de résonance (λ2) distincte de la première longueur d'onde de résonance (λ1), définissant une deuxième longueur d'onde de sensibilité du capteur.

5. Capteur (100 ; 400) selon la revendication 4, dans lequel chacune des première (D1 ; D12) et deuxième (D2 ; D11) cellules a une largeur comprise entre λm/2 et 2λm, où λm désigne la longueur d'onde moyenne de sensibilité du capteur.

6. Capteur (100 ; 400) selon la revendication 4 ou 5, dans lequel le réseau de résonance (107 ; 507) a un pas compris entre λm/4 et λm, où λm désigne la longueur d'onde moyenne de sensibilité du capteur.

7. Capteur (100 ; 400) selon l'une quelconque des revendications 4 à 6, dans lequel chacune des première (103), deuxième (105) et troisième (109) couches a une épaisseur comprise entre λm/8 et λm, où λm désigne la longueur d'onde moyenne de sensibilité du capteur.

8. Capteur (400) selon l'une quelconque des revendications 1 à 7, comportant en outre une troisième cellule photosensible (D22) formée dans le substrat (101), et une quatrième couche diélectrique (401) d'interface revêtant la troisième cellule (D22).

9. Capteur (400) selon la revendication 8 dans son rattachement à la revendication 4, dans lequel l'ensemble comprenant la quatrième couche diélectrique (401) d'interface et le réseau de résonance (107 ; 507) est choisi pour avoir une troisième longueur d'onde de résonance, distincte des première (λ1) et deuxième (λ2) longueurs d'onde de résonance, définissant une troisième longueur d'onde de sensibilité du capteur.

10. Capteur (100 ; 400) selon l'une quelconque des revendications 1 à 8, dans lequel chaque couche diélectrique (103, 105 ; 401) d'interface est en un matériau du groupe comprenant l'oxyde de silicium, le nitrure de silicium, le MgF₂, le HfO₂, le Al₂O₃, le Ta₂O₅, le TiO₂, le ZnS, et le ZrO₂.

11. Capteur (100 ; 400) selon l'une quelconque des revendications 1 à 9, dans lequel la troisième couche (109) est en un matériau du groupe comprenant le dioxyde de titane, le SiN, le Ta₂O₅, le HfO₂, le silicium et le germanium.
